# EUROPEAN PATENT APPLICATION

(11) **EP 4 658 026 A2**
(43) Date of publication of application: **03.12.2025**
(21) Application number: 25208724.2
(22) Date of filing: 14.10.2025
(51) Int. Cl.: H10F 10/19, H10K 85/50

(54) **TANDEM CELL**

(30) Priority: 29.08.2025 CN 202511232884; 29.08.2025 CN 202511232595
(71) Applicant: JINKO SOLAR CO., LTD, ShangRao, Jiangxi 334100 (CN); Jinko Solar (Haining) Co., Ltd., Haining City, Zhejiang 314415 (CN)
(72) Inventor: WANG, Jungan, Shangrao, JIANGXI, 334100 (CN); YAN, Xunlei, Shangrao, JIANGXI, 334100 (CN); XU, Menglei, Shangrao, JIANGXI, 334100 (CN); YANG, Jie, Shangrao, JIANGXI, 334100 (CN); ZHANG, Xinyu, Shangrao, JIANGXI, 334100 (CN)
(74) Representative: Ipsilon

(57) **Abstract**

A tandem cell includes: a silicon-based bottom cell including a substrate, the substrate having a first surface and a second surface that are opposite, a first tunneling oxide layer arranged on the first surface and a first passivation layer arranged on the first tunneling oxide layer; and a perovskite top cell arranged on the first passivation layer and electrically connected to the silicon-based bottom cell, the perovskite top cell including a hole transport layer, a perovskite active absorption layer, an electron transport layer, an interface buffer layer, a transparent conductive layer, an antireflection layer and a first electrode which are sequentially away from the first passivation layer, and the first electrode is configured to electrically contact the transparent conductive layer.

## Description

### TECHNICAL FIELD

The present invention relates to the technical field of solar cells, and in particular, to a tandem cell and a manufacturing method thereof.

### BACKGROUND

Due to excellent photoelectric properties such as a high light absorption coefficient, a large carrier diffusion length and a high defect tolerance, an organic-inorganic hybrid perovskite solar cell has a continuously rising efficiency, and the authenticated efficiency is increased from 3.8% to 26.1% in just more than ten years. In addition, a perovskite/crystalline silicon two-terminals tandem cell has larger efficiency potential, and currently, an authenticated efficiency of a two-terminals perovskite/HJT tandem cell reaches 34.85%, and an efficiency of a two-terminals perovskite/TOPCon tandem cell is relatively low.

### SUMMARY

Accordingly, it is necessary to provide a tandem cell and a manufacturing method of the tandem cell to solve the problem that an efficiency of a two-terminals perovskite/TOPCon tandem cell is not high.

A tandem cell includes: a silicon-based bottom cell including: a substrate having a first surface and a second surface that are opposite; a first tunneling oxide layer arranged on the first surface; and a first passivation layer arranged on the first tunneling oxide layer; and a perovskite top cell arranged on the first passivation layer and electrically connected to the silicon-based bottom cell, the perovskite top cell including: a hole transport layer, a perovskite active absorption layer, an electron transport layer, an interface buffer layer, a transparent conductive layer, an antireflection layer, and a first electrode that are sequentially stacked on the first passivation layer, and the first electrode is configured to electrically contact the transparent conductive layer.

In the present invention, the first doped crystalline silicon conductive layer is provided with the plurality of first opening regions, so that a ratio of the first doped crystalline silicon conductive layer is reduced, and light parasitic absorption is reduced, thereby increasing a short-circuit current of the tandem cell. In addition, the first passivation layer is additionally arranged above the first doped crystalline silicon conductive layer, thus increasing the short-circuit current and an open-circuit voltage of the perovskite tandem cell.

### BRIEF DESCRIPTION OF THE DRAWINGS

FIG. 1 is a schematic sectional diagram of a tandem cell according to one or more embodiments of the present invention.
FIG. 2 is a schematic sectional diagram of the tandem cell according to one or more embodiments of the present invention.
FIG. 3 is a schematic diagram of a first patterning manner of a first doped crystalline silicon conductive layer in one or more embodiments of the present invention.
FIG. 4 is a schematic diagram of a second patterning manner of the first doped crystalline silicon conductive layer in one or more embodiments of the present invention.
FIG. 5 is a schematic flow chart of a manufacturing method of a solar cell according to one or more embodiments of the present invention.
FIG. 6 is a schematic diagram after S100 of the manufacturing method.
FIG. 7 is a schematic diagram after S200 of the manufacturing method.
FIG. 8 is a schematic flow chart of S100 of the manufacturing method.
FIG. 9 is a schematic diagram after S110 of the manufacturing method.
FIG. 10 is a schematic diagram after S120 of the manufacturing method.
FIG. 11 is a schematic diagram after S130 of the manufacturing method.
FIG. 12 is a schematic diagram after S140 of the manufacturing method.
FIG. 13 is another schematic flow chart of the manufacturing method.
FIG. 14 is a schematic sectional diagram of a perovskite tandem cell.
FIG. 15 is a schematic flow chart of a manufacturing method of a solar cell according to one or more embodiments of the present invention.
FIG. 16 is a schematic diagram after step S100 of the manufacturing method.
FIG. 17 is a schematic diagram after step S200 of the manufacturing method.
FIG. 18 is a schematic flow chart of the step S100 of the manufacturing method.
FIG. 19 is a schematic diagram after S110 of the manufacturing method.
FIG. 20 is a schematic diagram after S120 of the manufacturing method.
FIG. 21 is a schematic diagram after S130 of the manufacturing method.
FIG. 22 is a schematic diagram after S140 of the manufacturing method.

### DETAILED DESCRIPTION

Unless the context indicates otherwise, materials described herein may be formed by any suitable technology, including, but not limited to, spin coating, blanket coating, chemical vapor deposition (CVD), plasma enhanced CVD (PECVD), atomic layer deposition (ALD), plasma enhanced ALD (PEALD), physical vapor deposition (PVD) (e.g., sputtering), or epitaxial growth. Technologies for depositing or growing the materials may be selected by one of ordinary skill in the art depending on the particular material to be formed.

In addition, unless the context indicates otherwise, material removal described herein may be realized by any suitable technology, including, but not limited to, etching (e.g., dry etching, wet etching, and vapor etching), ion milling, abrasive planarization (e.g., chemical mechanical planarization (CMP)), or other known methods.

The term "semiconductor" as used herein may refer to, for example, a material layer, a base, a wafer, or a substrate, and includes any base semiconductor structure. "Semiconductor" should be understood to include a silicon-on-sapphire (SOS) technology, a silicon-on-insulator (SOI) technology, a thin film transistor (TFT) technology, doped and undoped semiconductors, epitaxial silicon layers supported by the base semiconductor structure, as well as other semiconductor structures well known to one skilled in the art.

As described in the background, the two-terminals perovskite/TOPCon tandem cell has a relatively low efficiency. After research, the applicant found that one reason is that a continuous doped crystalline silicon structure of a TOPCon bottom cell has serious light parasitic absorption, and a short-circuit current of the tandem cell is influenced.

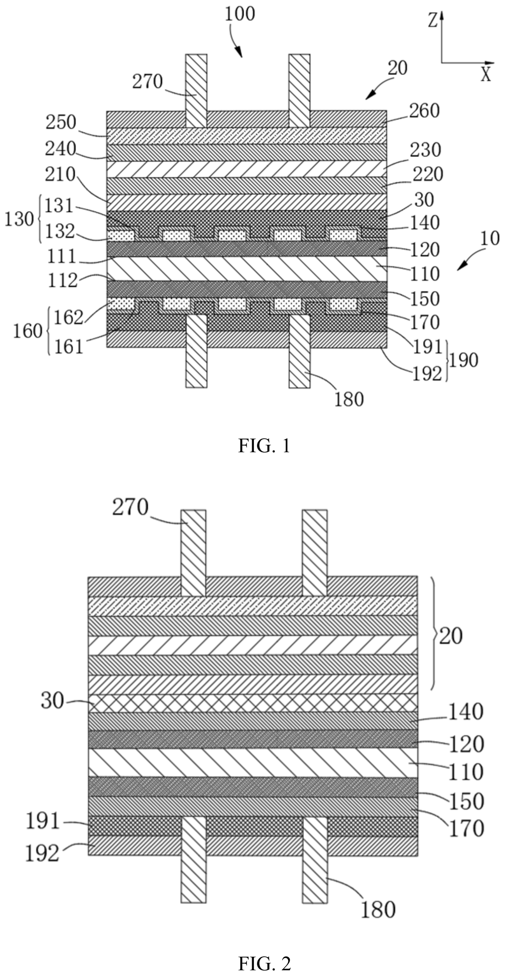

In order to solve the above problem, referring to FIG. 1, in a first aspect, an embodiment of the present invention provides a tandem cell 100, which includes a silicon-based bottom cell 10 and a perovskite top cell 20.

The silicon-based bottom cell 10 may be a tunnel oxide passivated contact (TOPCon) cell. The silicon-based bottom cell 10 includes a substrate 110, a first tunneling oxide layer 120, and a first passivation layer 140. The substrate 110 is configured to receive incident light and generate photogenerated carriers. The substrate 110 may be a semiconductor substrate 110. The substrate 110 may be made of, for example, at least one of monocrystalline silicon, polycrystalline silicon, amorphous silicon, and microcrystalline silicon. In some other embodiments, the material of the substrate 110 may be silicon carbide, an organic material, or a multi-element compound. The multi-element compound may include, but is not limited to, perovskite, gallium arsenide, cadmium telluride, copper indium selenium, or the like. The substrate 110 has a first surface 111 and a second surface 112 that are opposite to each other. When the tandem cell 100 works, the first surface 111 faces the sun, and the second surface 112 is away from the sun. The first tunneling oxide layer 120 is arranged on the first surface 111 in a direction perpendicular to and away from the first surface 111.

Referring to FIG. 1, in one embodiment, a first doped crystalline silicon conductive layer 130 and the first passivation layer 140 are arranged on the first tunneling oxide layer 120. The first doped crystalline silicon conductive layer 130 has a plurality of first opening regions 131 exposing the first tunneling oxide layer 120 or the substrate 110. The first passivation layer 140 covers a surface of the first doped crystalline silicon conductive layer 130 and surfaces of the first opening regions 131.

The first passivation layer 140 covers the surface of the first opening region 131, which means that the first passivation layer 140 covers a side wall and a bottom wall of the first opening region 131. Referring to FIG. 1, in some embodiments, the first opening region 131 only extends through the first doped crystalline silicon conductive layer 130 to expose the first tunneling oxide layer 120, and in this case, the first tunneling oxide layer 120 forms the bottom wall of the first opening region 131. In other embodiments, the first opening region 131 simultaneously extends through the first doped crystalline silicon conductive layer 130 and the first tunneling oxide layer 120, thereby exposing the substrate 110; in this case, the substrate 110 forms the bottom wall of the first opening region 131.

Referring to FIG. 1, the direction perpendicular to and away from the first surface 111 is the Z direction in the drawing, and a direction parallel to the first surface 111 is the X direction in the drawing.

The first tunneling oxide layer 120 and the first doped crystalline silicon conductive layer 130 are configured to form a passivation contact structure of the first surface 111 of the substrate 110, which can reduce a recombination of the carriers on the surface of the substrate, thereby increasing an open-circuit voltage of a solar cell and improving a photoelectric conversion efficiency of the solar cell. In an embodiment, the first tunneling oxide layer 120 may reduce a defect state concentration of the first surface 111 of the substrate 110, thereby reducing recombination centers of the first surface 111 of the substrate 110, and thus reducing a recombination rate of the carriers. In an example, a material of the first tunneling oxide layer 120 may include, but is not limited to, dielectric materials with a tunneling effect such as aluminum oxide, silicon oxide, silicon nitride, silicon oxynitride, intrinsic amorphous silicon, and intrinsic polycrystalline silicon. In an embodiment, the first tunneling oxide layer 120 may be formed of a silicon oxide layer including silicon oxide (SiOₓ) which has good passivation characteristics, and the carriers may easily tunnel through the silicon oxide layer.

In some embodiments, the first doped crystalline silicon conductive layer 130 is made of doped polycrystalline silicon, doped nanocrystalline silicon, or silicon carbide. In some embodiments, the first passivation layer 140 is made of one or a combination of aluminum oxide, silicon oxide, silicon nitride, titanium oxide, hafnium oxide, zirconium oxide, hydrogenated amorphous silicon, or the like, so as to provide a better passivation effect and meanwhile reduce parasitic absorption.

In some embodiments, the first doped crystalline silicon conductive layer 130 has a plurality of first opening regions 131. The first doped crystalline silicon conductive layer is patterned by, for example, laser to form the plurality of first opening regions 131. The first opening region 131 extends through the first doped crystalline silicon conductive layer 130, so that the underlying first tunneling oxide layer 120 can be exposed. Thus, the overlying first passivation layer 140 can cover the surface of the first doped crystalline silicon conductive layer 130 and a surface of the first tunneling oxide layer 120 at the same time.

In some embodiments, the first doped crystalline silicon conductive layer 130 is provided with the plurality of first opening regions 131, so that a ratio of the first doped crystalline silicon conductive layer 130 is reduced, and light parasitic absorption is reduced, thereby increasing a short-circuit current of the tandem cell. In addition, the first passivation layer 140 is additionally arranged above the first doped crystalline silicon conductive layer 130, thus increasing the short-circuit current and the open-circuit voltage of the tandem cell 100.

A formation manner of the first opening region 131 in FIG. 1 is not limited and may be implemented by various manners.

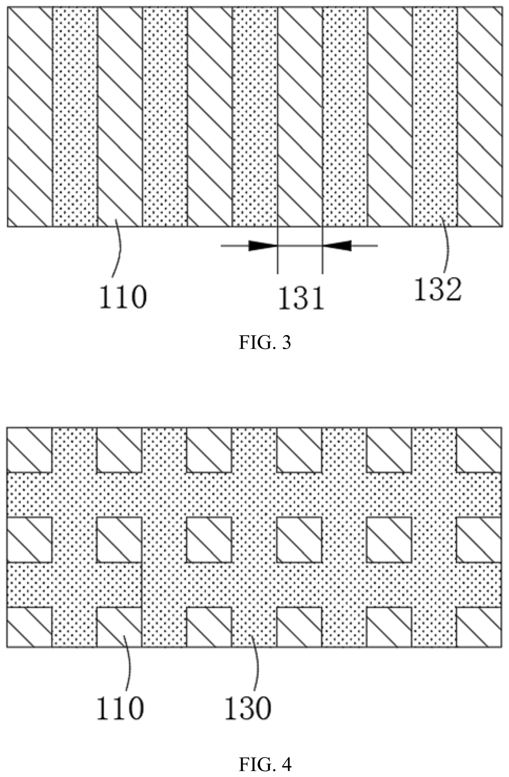

As an example, the first opening region 131 only extends through the first doped crystalline silicon conductive layer 130. In some embodiments, referring to FIG. 3, the first doped crystalline silicon conductive layer 130 includes a plurality of first doped crystalline silicon conductive regions 132 arranged at intervals, and the first opening regions 131 are formed between the adjacent first doped crystalline silicon conductive regions 132. In some embodiments, the first doped crystalline silicon conductive layer 130 is patterned by laser to remove parts of the first doped crystalline silicon conductive layer corresponding to the first opening regions 131. Thus, the plurality of first doped crystalline silicon conductive regions 132 arranged at intervals along a straight line are formed, and the first opening regions 131 are formed between the adjacent first doped crystalline silicon conductive regions 132. A similar manner is adopted when the first opening region 131 extends through the first doped crystalline silicon conductive layer 130 and the first tunneling oxide layer 120 at the same time.

In some embodiments, the first doped crystalline silicon conductive region 132 has a stripe shape. In other embodiments, the shape of the first doped crystalline silicon conductive region 132 is not limited to the stripe shape. For example, the first doped crystalline silicon conductive region 132 may have a saw-tooth shape, a curve shape, or the like. An area of all the first doped crystalline silicon conductive regions 132 may account for 20% to 80% of an area of the original first doped crystalline silicon conductive layer. In one or more embodiments, the area of all the first doped crystalline silicon conductive regions 132 accounts for 20%, 30%, 40%, 50%, 60%, 70%, or 80%. The first doped crystalline silicon conductive region 132 has a stripe shape. In one or more embodiments, in the direction parallel to the first surface 111, i.e., the X direction in FIG. 1, a width of the first doped crystalline silicon conductive region 132 is 50µm, 80µm, 120µm, 150µm, 200µm, or 250µm.

In some embodiments, referring to FIG. 4, the first doped crystalline silicon conductive layer 130 is a first grid lay-out structure. In an embodiment, the first doped crystalline silicon conductive layer is patterned by laser to form the first doped crystalline silicon conductive layer 130 in a grid shape. Meshes of the first grid lay-out structure form the first opening regions 131.

Referring again to FIG. 1, the perovskite top cell 20 is arranged on the first passivation layer 140 and electrically connected to the silicon-based bottom cell 10. The perovskite top cell 20 includes a hole transport layer 210, a perovskite active absorption layer 220, an electron transport layer 230, an interface buffer layer 240, a transparent conductive layer 250, an antireflection layer 260 and a first electrode 270 which are sequentially stacked on the first passivation layer 140, and the first electrode 270 is configured to be in electrical contact with the transparent conductive layer 250. The hole transport layer 210 may be made of one or a combination of Spiro-OMeTAD, Spiro-TTB, PTAA, Poly-TPD, PEDOT:PSS, P₃HT, Cu₂O, CuO, CuCaO₂, CuI, CuSCN, NiOₓ, and MoOₓ. The perovskite active absorption layer 220 is made of ABX3, in which A is a monovalent cation including one or a combination of cations of Li (lithium), Na (sodium), K (potassium), Rb (rubidium), Cs (cesium), MA (methylamine), and FA (formamidine), B is a divalent cation including one or a combination of cations of Cu (copper), Sn (tin), Pb (lead), Ag (silver), and In (indium), and X is a monovalent anion including one or more of anions of Cl (chloride), Br (bromide), and I (iodide). The ETL electron transport layer 230 is made of one or a combination of TiO₂, SnO₂, ZnO, ZnO₂, C60 fullerene and derivatives thereof, SnZnOₓ, SrTiO₃ and TiSnOₓ. The interface buffer layer 240 may be made of one or a combination of MoOₓ, SnO₂, ZnO, ZnO₂, and TiO₂. The transparent conductive layer 250 may be made of one or a combination of indium tin oxide (ITO), fluorine-doped tin oxide (FTO), indium zinc oxide (IZO), antimony-doped tin oxide (ATO), aluminum-doped zinc oxide (AZO), and zinc oxide, and the transparent conductive layer 250 is made of a conductive light-transmitting material. The first electrode 270 includes various types of metal electrodes, and a material includes, but is not limited to, silver, copper, tin, or the like, or mixed metal. Two or more first electrodes 270 may be provided, and each first electrode 270 is in electrical ohmic contact with the transparent conductive layer 250.

In some embodiments, referring to FIG. 1, a first conductive film layer 30 is further arranged between the hole transport layer 210 and the first passivation layer 140. The first conductive film layer 30 is made of a conductive light-transmitting material that allows light not absorbed by the perovskite top cell 20 to be transmitted to the maximum extent and fully utilized by the silicon-based bottom cell 10. The first conductive film layer 30 is made of, for example, one or a combination of indium tin oxide (ITO), fluorine-doped tin oxide (FTO), indium zinc oxide (IZO), antimony-doped tin oxide (ATO), aluminum-doped zinc oxide (AZO), and zinc oxide.

In some embodiments, referring to FIG. 1, in a direction perpendicular to and away from the second surface 112, the silicon-based bottom cell 10 further includes a second tunneling oxide layer 150 arranged on the second surface 112. A second doped crystalline silicon conductive layer 160 and a second passivation layer 170 are arranged on the second tunneling oxide layer 150. The second doped crystalline silicon conductive layer 160 has a plurality of second opening regions 161 exposing the second tunneling oxide layer 150 or the substrate 110, and the second passivation layer 170 covers a surface of the second doped crystalline silicon conductive layer 160 and surfaces of the second opening regions 161. The silicon-based bottom cell 10 further includes a second electrode 180, the second electrode 180 being arranged on the second passivation layer 170 and in electrical contact with the second doped crystalline silicon conductive layer 160.

The second passivation layer 170 covers the surface of the second opening region 161, which means that the second passivation layer 170 covers a side wall and a bottom wall of the second opening region 161. Referring to FIG. 1, in some embodiments, the second opening region 161 only extends through the second doped crystalline silicon conductive layer 160 to expose the second tunneling oxide layer 150, and in this case, the second tunneling oxide layer 150 forms the bottom wall of the second opening region 161. In other embodiments, the second opening region 161 simultaneously extends through the second doped crystalline silicon conductive layer 160 and the second tunneling oxide layer 150, thereby exposing the substrate 110; in this case, the substrate 110 forms the bottom wall of the second opening region 161.

The second tunneling oxide layer 150 can reduce an interface state density between the second doped crystalline silicon conductive region 162 and the substrate 110, reduce a carrier recombination probability, and improve an efficiency of the solar cell. In an embodiment, the second tunneling oxide layer 150 may be formed of a silicon oxide layer including silicon oxide (SiOx) which has good passivation characteristics, and the carriers may easily tunnel through the silicon oxide layer.

In more embodiments, the second doped crystalline silicon conductive layer 160 is made of doped polycrystalline silicon, doped nanocrystalline silicon, or silicon carbide. In one or more embodiments, the second passivation layer 170 is made of one or a combination of aluminum oxide, silicon oxide, silicon nitride, titanium oxide, hafnium oxide, zirconium oxide, hydrogenated amorphous silicon, or the like, so as to provide a better passivation effect and meanwhile reduce parasitic absorption.

Referring to FIG. 1, when the second tunneling oxide layer 150 is provided with the second doped crystalline silicon conductive layer 160 and the second passivation layer 170, the second doped crystalline silicon conductive layer 160 has a plurality of second opening regions 161. The second doped crystalline silicon conductive layer is patterned to form the plurality of second opening regions 161. The second opening region 161 extends through the second doped crystalline silicon conductive layer, so that the underlying second tunneling oxide layer 150 can be exposed. Thus, the overlying second passivation layer 170 can cover the surface of the second doped crystalline silicon conductive layer 160 and a surface of the second tunneling oxide layer 150 at the same time.

With the above design, the second surface 112 of the silicon-based bottom cell 10 away from the perovskite top cell 20 is provided with a passivation contact structure formed by the second tunneling oxide layer 150 and the second doped crystalline silicon conductive layer 160, and the second doped crystalline silicon conductive layer 160 is provided with the plurality of second opening regions 161, so that a ratio of the second doped crystalline silicon conductive layer 160 is reduced, and light parasitic absorption is reduced, thereby increasing the short-circuit current of the tandem cell. In addition, the second passivation layer 170 is additionally arranged above the second doped crystalline silicon conductive layer 160, thus increasing the short-circuit current and the open-circuit voltage of the tandem cell 100.

The second doped crystalline silicon conductive layer 160 may be patterned in the same manner as the first doped crystalline silicon conductive layer 130. In an embodiment, the second doped crystalline silicon conductive layer 160 includes a plurality of second doped crystalline silicon conductive regions 162 arranged at intervals, and the second opening regions 161 are formed between the adjacent second doped crystalline silicon conductive regions 162. Alternatively, the second doped crystalline silicon conductive layer 160 is a second grid lay-out structure. Meshes of the second grid lay-out structure form the second opening regions 161. The second doped crystalline silicon conductive region has a stripe shape. In one or more embodiments, a width of the second doped crystalline silicon conductive region 162 is 50µm, 80µm, 120µm, 150µm, 200µm, or 250µm.

Further, a surface passivation structure 190 may be further arranged on the second passivation layer 170. The surface passivation structure 190 includes, for example, a passivation film 191 and an antireflection film 192. The passivation film 191 can ensure a good passivation effect on the second surface of the substrate 110. The antireflection film 192 can reduce an optical reflection loss of the second surface of the substrate 110, and improve a light absorption efficiency of the silicon-based bottom cell 10.

The passivation film 191 may be made of one of silicon oxide, aluminum oxide, silicon nitride, and silicon oxynitride. The passivation film 191 may have a single layer structure or a multilayer structure. For the multilayer structure, materials of different layers may be different from each other, and alternatively, the materials of some layers may be the same and different from the materials of other layers. For example, the passivation film 191 may have a multilayer structure of a silicon nitride layer and an aluminum oxide layer.

The antireflection film 192 may be made of one of silicon oxide, aluminum oxide, silicon nitride, and silicon oxynitride. The antireflection film 192 may have a single layer structure or a multilayer structure. For the multilayer structure, materials of different layers may be different from each other, and alternatively, the materials of some layers may be the same and different from the materials of other layers. For example, the antireflection film 192 may have a multilayer structure of a silicon nitride layer and an aluminum oxide layer.

In some embodiments, the substrate 110 is an N-type substrate, and the first doped crystalline silicon conductive layer 130 and the first tunneling oxide layer 120 each contains N-type doped elements, and the second doped crystalline silicon conductive layer 160 and the second tunneling oxide layer 150 each contains P-type doped elements.

The substrate 110 has a doped element therein, and the doped element may be N-type or P-type. The N-type element may be group-V elements such as phosphorus (P), bismuth (Bi), antimony (Sb), or arsenic (As); the P-type element may be group-III elements such as boron (B), aluminum (Al), gallium (Ga), or indium (In). For example, when the substrate 110 is an N-type substrate 110, the internal doped element thereof is N-type.

In some embodiments, the substrate 110 may be an N-type substrate, and the substrate 110 may be doped with N-type doped ions, which may be, for example, any of phosphorous ions, bismuth ions, antimony ions, and arsenic ions.

Correspondingly, the first doped crystalline silicon conductive layer 130 and the first tunneling oxide layer 120 contain the N-type doped elements. The first doped crystalline silicon conductive layer 130 and the first tunneling oxide layer 120 may have doped elements with the same conductive type as the substrate 110. The doped element may be, for example, any of phosphorus ions, bismuth ions, antimony ions, and arsenic ions. The second doped crystalline silicon conductive layer 160 and the second tunneling oxide layer 150 contain doped elements with the opposite conductive type to the substrate 110. The doped element may be, for example, boron ions, aluminum ions, or the like.

Referring to FIG. 2, unlike the embodiment shown in FIG. 1, in some embodiments, the first passivation layer 140 is arranged on the first tunneling oxide layer 120, that is, the first passivation layer 140 directly covers the first tunneling oxide layer 120. That is, when the first doped crystalline silicon conductive layer 130 is patterned, the whole first doped crystalline silicon conductive layer 130 is removed, and then, the first passivation layer 140 is deposited on the first tunneling oxide layer 120.

In some embodiments, since the first doped crystalline silicon conductive layer 130 is eliminated, light parasitic absorption can be reduced, and thus, the short-circuit current of the tandem cell can be increased. In addition, the first passivation layer 140 is additionally arranged, thus increasing the short-circuit current and the open-circuit voltage of the tandem cell 100.

In addition, referring to FIG. 2, unlike the embodiment shown in FIG. 1, in some embodiments, the second passivation layer 170 directly covers the second tunneling oxide layer 150. That is, when the second doped crystalline silicon conductive layer 160 is patterned, the whole second doped crystalline silicon conductive layer 160 is removed, and then, the second passivation layer 170 is deposited. Since the second doped crystalline silicon conductive layer 160 is eliminated, light parasitic absorption is reduced, and thus, the short-circuit current of the tandem cell is increased. In addition, the second passivation layer 170 is additionally arranged, thus increasing the short-circuit current and the open-circuit voltage of the tandem cell 100.

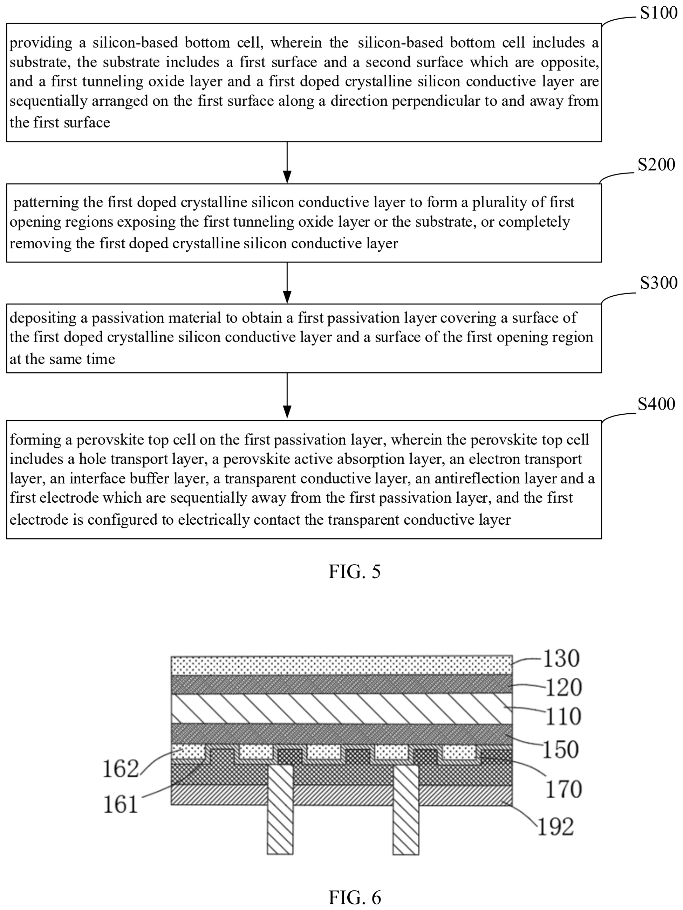

Referring to FIG. 5, in a second aspect, an embodiment of the present invention provides a manufacturing method of a tandem cell 100, and the tandem cell 100 in the first aspect can be manufactured. The manufacturing method of a tandem cell 100 includes the following steps.

S100: providing a silicon-based bottom cell 10, wherein the silicon-based bottom cell 10 includes a substrate 110, the substrate 110 includes a first surface 111 and a second surface 112 which are opposite, and a first tunneling oxide layer 120 and a first doped crystalline silicon conductive layer 130 are sequentially arranged on the first surface 111 along a direction perpendicular to and away from the first surface 111.

Referring to FIG. 6, in this step, the silicon-based bottom cell 10 is an N-type cell, and the substrate 110 is an N-type substrate 110. The first surface 111 of the substrate 110 is provided with the first tunneling oxide layer 120 and the first doped crystalline silicon conductive layer. In this step, the first doped crystalline silicon conductive layer 130 is an entire layer structure covering the first tunneling oxide layer 120.

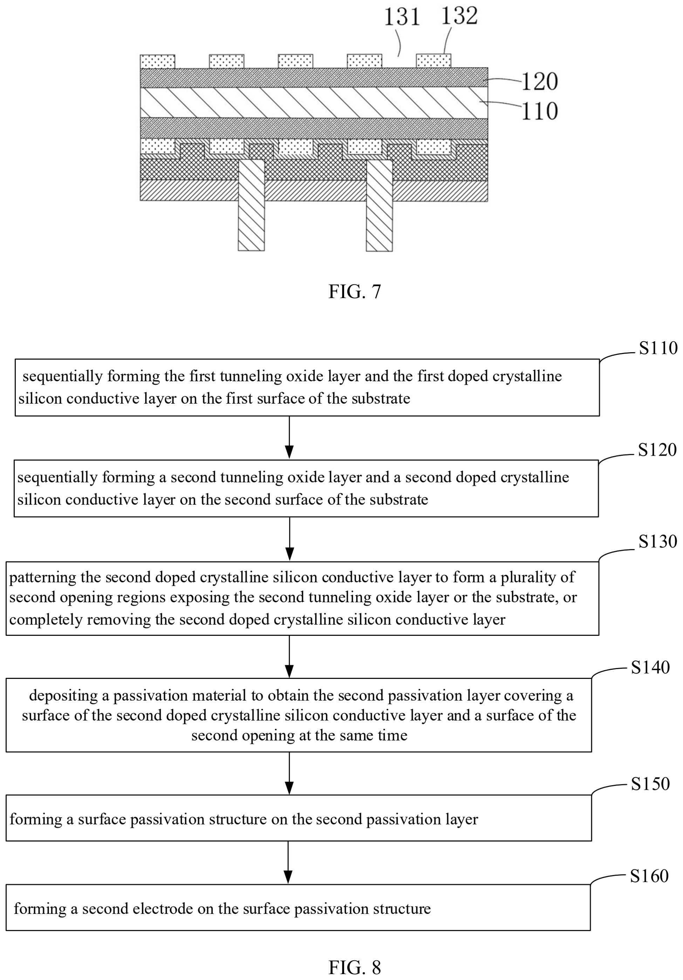

S200: patterning the first doped crystalline silicon conductive layer 130 to form a plurality of first opening regions 131 exposing the first tunneling oxide layer 120 or the substrate 110, or completely removing the first doped crystalline silicon conductive layer 130. Reference is made to FIG. 7.

In some embodiments, the first doped crystalline silicon conductive layer is patterned by using ultraviolet picosecond laser, excess parts of the first doped crystalline silicon conductive layer 130 are removed, and remaining parts of the first doped crystalline silicon conductive layer 130 form the plurality of first doped crystalline silicon conductive regions 132, as shown in FIG. 3. Alternatively, the whole first doped crystalline silicon conductive layer 130 is removed.

S300: depositing a passivation material to obtain a first passivation layer 140 covering a surface of the first doped crystalline silicon conductive layer 130 and a surface of the first opening region 131 at the same time.

In one or more embodiments, aluminum oxide is deposited through ALD to form the first passivation layer 140. It is easily understood that, referring to FIG. 1, when only a part of the first doped crystalline silicon conductive layer 130 is removed, the first passivation layer 140 covers a top surface of the first doped crystalline silicon conductive layer 130, and a side wall and a bottom wall of the first opening region 131. In this case, the side wall of the first opening region 131 is formed by the first doped crystalline silicon conductive layer 130, and the bottom wall of the first opening region 131 is formed by the first tunneling oxide layer 120.

Referring to FIG. 2, when the whole first doped crystalline silicon conductive layer 130 is removed, the first passivation layer 140 directly covers the first tunneling oxide layer 120.

S400: forming a perovskite top cell 20 on the first passivation layer 140, wherein the perovskite top cell 20 includes a hole transport layer 210, a perovskite active absorption layer 220, an electron transport layer 230, an interface buffer layer 240, a transparent conductive layer 250, an antireflection layer 260 and a first electrode 270 that are sequentially stacked on the first passivation layer 140, and the first electrode 270 is configured to be in electrical contact with the transparent conductive layer 250.

In an embodiment, referring to FIG. 1 or FIG. 2, materials are sequentially deposited on the first passivation layer 140 to form the hole transport layer 210, the perovskite active absorption layer 220, the electron transport layer 230, the interface buffer layer 240, the transparent conductive layer 250, the antireflection layer 260, and the first electrode 270 in electrical contact with the transparent conductive layer 250, thereby forming the tandem cell.

In the manufacturing method of a tandem cell 100 according to the present invention, by removing a part or all of the first doped crystalline silicon conductive layer 130, a ratio of the first doped crystalline silicon conductive layer 130 is reduced, and light parasitic absorption is reduced, thereby increasing a short-circuit current of the tandem cell. In addition, a second passivation layer 170 is additionally arranged above the first doped crystalline silicon conductive layer 130, thus increasing the short-circuit current and an open-circuit voltage of the tandem cell 100.

In some embodiments, referring to FIG. 8, S100 includes the following steps.

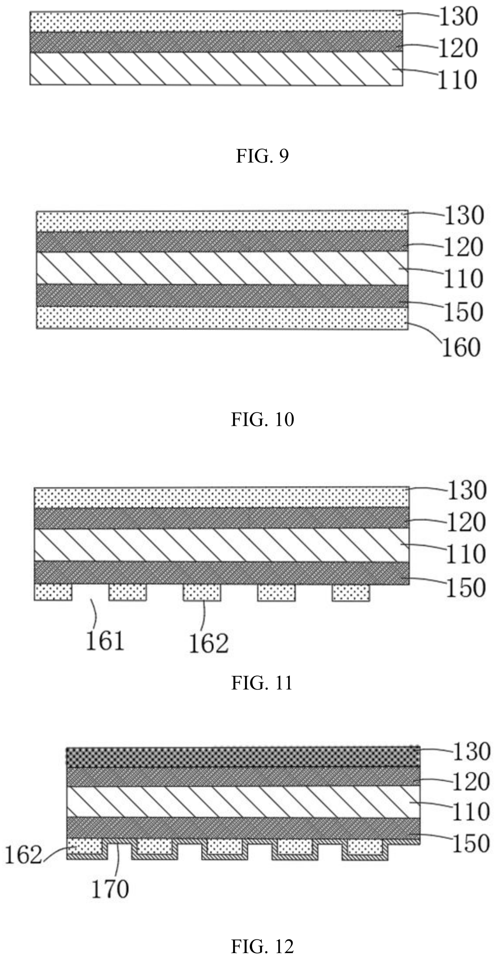

S110: sequentially forming the first tunneling oxide layer 120 and the first doped crystalline silicon conductive layer on the first surface 111 of the substrate 110, as shown in FIG. 9.

S120: sequentially forming a second tunneling oxide layer 150 and a second doped crystalline silicon conductive layer on the second surface 112 of the substrate 110, as shown in FIG. 10.

S130: patterning the second doped crystalline silicon conductive layer 160 to form a plurality of second opening regions 161 exposing the second tunneling oxide layer 150 or the substrate 110, as shown in FIG. 11; or completely removing the second doped crystalline silicon conductive layer 160.

S140: depositing a passivation material to obtain the second passivation layer 170 covering a surface of the second doped crystalline silicon conductive layer 160 and a surface of the second opening 161 at the same time, as shown in FIG. 12, or the second passivation layer 170 covering the surface of the second tunneling oxide layer 150.

In one or more embodiments, aluminum oxide is deposited through ALD to form the second passivation layer 170. It is easily understood that, referring to FIG. 1, when only a part of the second doped crystalline silicon conductive layer 160 is removed, the second passivation layer 170 covers a top surface of the second doped crystalline silicon conductive layer 160, and a side wall and a bottom wall of the second opening region 161. In this case, the side wall of the second opening region 161 is formed by the second doped crystalline silicon conductive layer 160, and the bottom wall of the second opening region 161 is formed by the second tunneling oxide layer 150.

Referring to FIG. 2, when the whole second doped crystalline silicon conductive layer 160 is removed, the second passivation layer 170 directly covers the second tunneling oxide layer 150.

S150: forming a surface passivation structure 190 on the second passivation layer 170, as shown in FIG. 1.

S160: forming a second electrode 180 on the surface passivation structure 190. The second electrode 180 is in contact with the second doped crystalline silicon conductive layer 160, as shown in FIG. 11, or in contact with the second passivation layer 170.

In some embodiments, the first surface 111 and the second surface 112 of the substrate 110 may be textured with an alkali solution and a texturing additive respectively to form micro-scale pyramid structures. Then, silicon oxide and polycrystalline silicon are deposited on the first surface by LPCVD, and then, phosphorus diffusion is performed to obtain the first tunneling oxide layer 120 and the first doped crystalline silicon conductive layer. Silicon oxide and polycrystalline silicon are deposited on the second surface by LPCVD, and then, boron diffusion is performed to obtain the second tunneling oxide layer 150 and the second doped crystalline silicon conductive layer. The first doped crystalline silicon conductive layer and the second doped crystalline silicon conductive layer are patterned by adopting ultraviolet picosecond laser, the first doped crystalline silicon conductive layer is partially or completely removed, and the second doped crystalline silicon conductive layer is partially or completely removed. Aluminum oxide is deposited through ALD to form the first passivation layer 140 or the second passivation layer 170. Finally, the electrode is deposited by adopting screen printing to form the complete crystalline silicon cell.

With the above manner, on the first surface of the silicon-based bottom cell 10 facing the perovskite top cell 20 and the second surface of the silicon-based bottom cell 10 opposite to the perovskite top cell, the first doped crystalline silicon conductive layer and the second doped crystalline silicon conductive layer are partially or completely removed through patterning, so that the ratios of the first doped crystalline silicon conductive layer and the second doped crystalline silicon conductive layer are reduced, and light parasitic absorption is reduced, thereby increasing the short-circuit current of the tandem cell. In addition, the first passivation layer 140 and the second passivation layer 170 are additionally arranged, thus increasing the short-circuit current and an open-circuit voltage of the tandem cell 100.

In the present invention, the passivation material includes one or a combination of aluminum oxide, silicon oxide, silicon nitride, titanium oxide, hafnium oxide, zirconium oxide, hydrogenated amorphous silicon, or the like, so as to provide a better passivation effect and meanwhile reduce parasitic absorption.

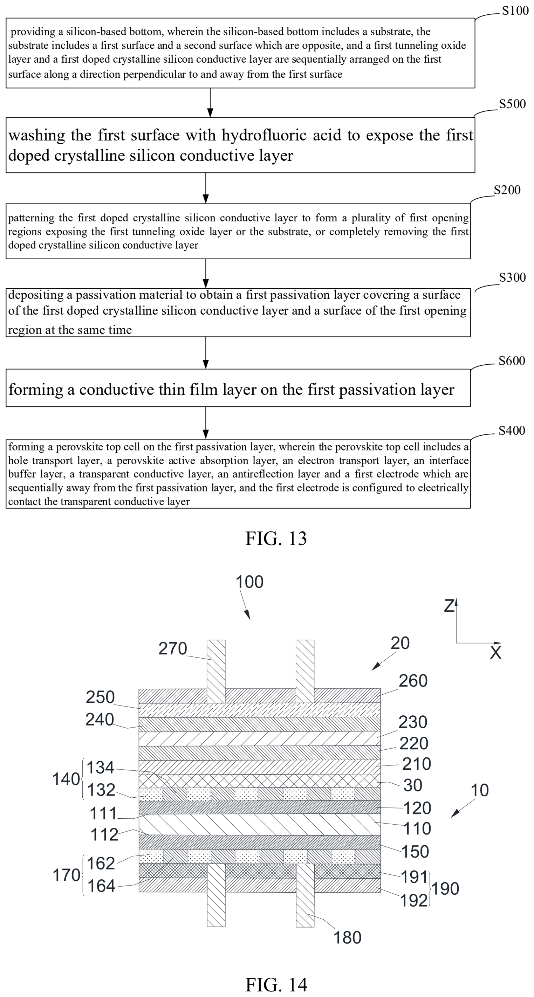

In some embodiments, referring to FIG. 13, before S200, the manufacturing method further includes S500: washing the first surface 111 with hydrofluoric acid to expose the first doped crystalline silicon conductive layer.

In this step, the hydrofluoric acid (HF) is adopted for washing to remove surface metallization, silicon nitride and oxide layers, and the first doped crystalline silicon conductive layer is exposed, so that the first doped crystalline silicon conductive layer can be conveniently patterned.

In some embodiments, referring to FIG. 13, before S400, the manufacturing method further includes S600: forming a first conductive film layer 30 on the first passivation layer 140. For example, the first conductive film layer 30 is formed by depositing ITO by magnetron sputtering, and can be used as an intermediate composite layer of the tandem cell.

The tandem cell 100 according to the embodiment of the present invention will be illustrated below in conjunction with some examples and related comparative examples.

### First example

A silicon wafer was provided, and a surface of the silicon wafer was textured by adopting an alkali solution and a texturing additive to form a micro-scale pyramid structure; silicon oxide and polycrystalline silicon were deposited by LPCVD, and then, boron diffusion was performed to obtain a second tunneling oxide layer 150 and a second doped crystalline silicon conductive layer.

Silicon oxide and polycrystalline silicon were deposited by LPCVD, and then, phosphorus diffusion was performed to obtain a first tunneling oxide layer 120 and a first doped crystalline silicon conductive layer 130.

The second doped crystalline silicon conductive layer 160 was patterned by using ultraviolet picosecond laser, so as to remove 70% of the second doped crystalline silicon conductive layer 160, that is, reserve 30% of the second doped crystalline silicon conductive region 162, and a formed second doped crystalline silicon conductive region 162 is in a strip shape and has a width of 50µm.

Aluminum oxide was deposited by ALD as a second passivation layer 170 with a thickness of 3nm, which provides a better passivation effect and meanwhile reduces parasitic absorption.

A second electrode 180 was deposited by using screen printing to form a complete silicon-based bottom cell 10.

Surface metallization, silicon nitride and oxide layers were removed by HF washing, so as to expose the first doped crystalline silicon conductive layer 130.

The first doped crystalline silicon conductive layer 130 was patterned by ultraviolet picosecond laser, so as to remove 70% of the first doped crystalline silicon conductive layer 130, that is, an area of a left first doped crystalline silicon conductive region 132 accounts for 30% of an area of the first doped crystalline silicon conductive layer 130, and the formed first doped crystalline silicon conductive region 132 is in a strip shape and has a width of 50µm.

Aluminum oxide was deposited by ALD as a first passivation layer 140 with a thickness of 3nm, which provides a better passivation effect and meanwhile reduces parasitic absorption.

50nm ITO (indium zinc oxide) was deposited by magnetron sputtering as a first conductive film layer 30 as an intermediate composite layer of a tandem cell.

A hole transport layer 210, a perovskite active absorption layer 220, an electron transport layer 230, an interface buffer layer 240, a transparent conductive layer 250, an antireflection layer 260 and a first electrode 270 were sequentially deposited to form the complete tandem cell.

Second example: the second example is different from the first example in that the first doped crystalline silicon conductive layer 130 and the second doped crystalline silicon conductive layer 160 were completely removed.

Third example: the third example is different from the first example in that the first doped crystalline silicon conductive region 132 has a width of 200um and the second doped crystalline silicon conductive region 162 has a width of 200um.

Fourth example: the fourth example is different from the first example in that materials of the first passivation layer 140 and the second passivation layer 170 are titanium oxide. A bandgap of the titanium oxide is wider than that of the nanocrystalline silicon oxide of the first example, the short-circuit current is higher than that of the first example, and meanwhile, the titanium oxide can provide better passivation and thus realizes a higher open-circuit voltage.

First comparative example: the first comparative example is different from the first example in that the steps of patterning the first doped crystalline silicon conductive layer 130 and the second doped crystalline silicon conductive layer 160 and the steps of depositing passivation materials to form the first passivation layer 140 and the second passivation layer 170 were omitted.

IV volt-ampere characteristic curves of the above tandem cells were tested, and the test was performed with reference to GBT6495.1 (name: IEC60904-2008). Testing conditions: spectrum: AM1.5G, light intensity: 1,000W/m2, and temperature: 25°C. Test results are given in the table below.

**Table 1**

| | Voc(V) Open-circuit voltage | Jsc(mA/cm2) Short-circuit current density | FF(%) Filling factor | PCE(%) |
|---|---|---|---|---|
| First comparative example | 1.884 | 19.23 | 81.23 | 29.43 |
| First example | 1.925 | 19.67 | 82.25 | 31.14 |
| Second example | 1.918 | 19.85 | 83.05 | 31.62 |
| Third example | 1.909 | 19.28 | 81.63 | 29.73 |
| Fourth example | 1.920 | 19.43 | 81.78 | 30.30 |

As can be seen from table 1, compared with the comparative example, the tandem cell 100 according to the embodiment of the present invention has a better filling factor, a higher open-circuit voltage, and a larger short-circuit current density as a whole.

Referring to FIG. 14, an embodiment of the present invention provides a tandem cell 100, which includes a silicon-based bottom cell 10 and a perovskite top cell 20.

The silicon-based bottom cell 10 includes a substrate 110, a first tunneling oxide layer 120, and a first passivation layer 140. The substrate 110 includes a first surface 111 and a second surface 112 opposite to each other. The first tunneling oxide layer 120 and the first passivation layer 140 are sequentially arranged on the first surface 111 in a direction perpendicular to and away from the first surface 111. In a direction parallel to the first surface 111, the first passivation layer 140 includes first doped crystalline silicon conductive regions 132 and first doped crystalline silicon conductive regions 134 alternately arranged.

The silicon-based bottom cell 10 may be a tunnel oxide passivated contact (TOPCon) cell. The substrate 110 is configured to receive incident light and generate photogenerated carriers. The substrate 110 is a semiconductor substrate 110. The substrate 110 may be made of, for example, at least one of monocrystalline silicon, polycrystalline silicon, amorphous silicon, and microcrystalline silicon. In some other embodiments, the material of the substrate 110 may be silicon carbide, an organic material, or a multi-element compound. The multi-element compound may include, but is not limited to, perovskite, gallium arsenide, cadmium telluride, copper indium selenium, or the like. Here, when the tandem cell 100 works, the first surface 111 faces the sun. The second surface 112 is a backlight surface, which refers to a surface of the tandem cell 100 facing away from the sun during working.

Referring to FIG. 14, the direction perpendicular to and away from the first surface 111 is the Z direction in the drawing, and the direction parallel to the first surface 111 is the X direction in the drawing. The first tunneling oxide layer 120 and the first passivation layer 140 are sequentially arranged in the Z direction. The first passivation layer 140 includes the first doped crystalline silicon conductive regions 132 and the first doped crystalline silicon conductive regions 134 alternately arranged. The first tunneling oxide layer 120 can reduce an interface state density between the first doped crystalline silicon conductive region 132 and the substrate 110, reduce a carrier recombination probability, and improve an efficiency of the solar cell.

The first tunneling oxide layer 120 and the first passivation layer 140 may be configured to form a passivation contact structure of the surface of the substrate 110, which can reduce a recombination of the carriers on the surface of the substrate, thereby increasing an open-circuit voltage of the solar cell and improving a photoelectric conversion efficiency of the solar cell. In an embodiment, the first tunneling oxide layer 120 may reduce a defect state concentration of the first surface 111 of the substrate 110, thereby reducing recombination centers of the first surface 111 of the substrate 110, and thus reducing a recombination rate of the carriers. In an example, a material of the first tunneling oxide layer 120 may include, but is not limited to, dielectric materials with a tunneling effect such as aluminum oxide, silicon oxide, silicon nitride, silicon oxynitride, intrinsic amorphous silicon, and intrinsic polycrystalline silicon. In an embodiment, the first tunneling oxide layer 120 may be formed of a silicon oxide layer including silicon oxide (SiOₓ) which has good passivation characteristics, and the carriers may easily tunnel through the silicon oxide layer.

In some embodiments, the first doped crystalline silicon conductive region 132 is made of doped polycrystalline silicon, doped nanocrystalline silicon, or silicon carbide.

In the first passivation layer 140, the first doped crystalline silicon conductive region 134 has an energy bandgap greater than that of silicon (e.g., 1.12eV). The first doped crystalline silicon conductive region 134 is a wide bandgap passivation layer that provides a better passivation effect and meanwhile reduces parasitic absorption. The wide bandgap passivation layer is a protective film formed on a surface of a semiconductor device by using an insulating dielectric material (such as tungsten disulfide, molybdenum disulfide, titanium oxide, molybdenum oxide, tungsten oxide, hydrogenated amorphous silicon carbide, amorphous silicon oxide or metal oxide) with a quite large energy bandgap (much larger than that of silicon). The wide bandgap passivation layer has the core value that a harmful recombination on a surface of a semiconductor is remarkably reduced through excellent insulativity, a high voltage endurance capability and an effective chemical/field effect passivation mechanism, so that an efficiency, a performance and reliability of the device (especially a high-efficiency solar cell and a power semiconductor) are greatly improved.

In the present invention, the first surface 111 of the silicon-based bottom cell 10 facing the perovskite top cell 20 is provided with the passivation contact structure formed by the first tunneling oxide layer 120 and the first passivation layer 140. The first passivation layer 140 includes the first doped crystalline silicon conductive regions 132 and the first doped crystalline silicon conductive regions 134 alternately arranged along the X direction, so that a ratio of the first doped crystalline silicon conductive regions 132 is reduced, and light parasitic absorption is reduced, thereby increasing a short-circuit current of the tandem cell.

In some embodiments, the first doped crystalline silicon conductive region 132 and the first doped crystalline silicon conductive region 134 have equal thicknesses in the direction perpendicular to and away from the first surface 111.

Referring to FIG. 14, the equal thicknesses of the first doped crystalline silicon conductive region 132 and the first doped crystalline silicon conductive region 134 in the Z direction means that the thicknesses are substantially equal. In other words, the thicknesses are considered to be equal even though there is a process error.

In some embodiments, referring to FIG. 14, an area of all the first doped crystalline silicon conductive regions 132 accounts for 20% to 80% of an area of the first passivation layer 140. In one or more embodiments, the area of all the first doped crystalline silicon conductive regions 132 accounts for 20%, 30%, 40%, 50%, 60%, 70%, or 80% of the area of the first passivation layer 140.

In an embodiment, the first doped crystalline silicon conductive region 132 and the first doped crystalline silicon conductive region 134 are both in a strip shape. The area of the first doped crystalline silicon conductive region 132 accounts for 70% of the total area of the first passivation layer 140 and an area of the first doped crystalline silicon conductive region 134 accounts for 30% of the total area of the first passivation layer 140.

In other embodiments, the first doped crystalline silicon conductive region 132 and the first doped crystalline silicon conductive region 134 are not limited to the stripe shape. For example, taking the first doped crystalline silicon conductive region 132 as an example, the first doped crystalline silicon conductive region 132 may have a saw-tooth shape, a curve shape, or the like.

In some embodiments, in the direction parallel to the first surface 111, each of the first doped crystalline silicon conductive regions 132 has a width of 50 to 250µm. In one or more embodiments, the width of the first doped crystalline silicon conductive region 132 is 50µm, 80µm, 120µm, 150µm, 200µm, or 250µm.

The perovskite top cell 20 is arranged on the first passivation layer 140 and electrically connected to the silicon-based bottom cell 10. The perovskite top cell 20 includes a hole transport layer 210, a perovskite active absorption layer 220, an electron transport layer 230, an interface buffer layer 240, a transparent conductive layer 250, an antireflection layer 260 and a first electrode 270 which are sequentially away from the first passivation layer 140, and the first electrode 270 is configured to be in electrical contact with the transparent conductive layer 250. The hole transport layer 210 may be made of one or a combination of Spiro-OMeTAD, Spiro-TTB, PTAA, Poly-TPD, PEDOT:PSS, P₃HT, Cu₂O, CuO, CuCaO₂, CuI, CuSCN, NiOₓ, and MoOₓ. The perovskite active absorption layer 220 is made of ABX₃, in which A is a monovalent cation including one or a combination of cations of Li (lithium), Na (sodium), K (potassium), Rb (rubidium), Cs (cesium), MA (methylamine), and FA (formamidine), B is a divalent cation including one or a combination of cations of Cu (copper), Sn (tin), Pb (lead), Ag (silver), and In (indium), and X is a monovalent anion including one or more of anions of Cl (chloride), Br (bromide), and I (iodide). The ETL electron transport layer 230 is made of one or a combination of TiO₂, SnO₂, ZnO, ZnO₂, C60 fullerene and derivatives thereof, SnZnOₓ, SrTiO₃ and TiSnOₓ. The interface buffer layer 240 may be made of one or a combination of MoOₓ, SnO₂, ZnO, ZnO₂, and TiO₂. The transparent conductive layer 250 may be made of one or a combination of indium tin oxide (ITO), fluorine-doped tin oxide (FTO), indium zinc oxide (IZO), antimony-doped tin oxide (ATO), aluminum-doped zinc oxide (AZO), and zinc oxide, and the transparent conductive layer 250 is made of a conductive light-transmitting material. The first electrode 270 includes various types of metal electrodes, and a material includes, but is not limited to, silver, copper, tin, or the like, or mixed metal. Two or more first electrodes 270 may be provided, and each first electrode 270 is in electrical ohmic contact with the transparent conductive layer 250.

In some embodiments, referring to FIG. 14, a second conductive film layer 30 is further arranged between the perovskite top cell 20 and the first passivation layer 140. The second conductive film layer 30 is made of a conductive light-transmitting material that allows light not absorbed by the perovskite top cell 20 to be transmitted to the maximum extent and fully utilized by the silicon-based bottom cell 10. The second conductive film layer 30 is made of, for example, one or a combination of indium tin oxide (ITO), fluorine-doped tin oxide (FTO), indium zinc oxide (IZO), antimony-doped tin oxide (ATO), aluminum-doped zinc oxide (AZO), and zinc oxide.

In some embodiments, the silicon-based bottom cell 10 further includes a second tunneling oxide layer 150, a second passivation layer 170, a surface passivation structure 190, and a second electrode 180 sequentially stacked on the second surface 112 in a direction perpendicular to and away from the second surface 112. The second passivation layer 170 includes second doped crystalline silicon conductive regions 162 and second wide bandgap conductive regions 164 alternately arranged in a direction parallel to the second surface 112, and the second electrode 180 contacts the second doped crystalline silicon conductive region 162.

The second tunneling oxide layer 150 can reduce an interface state density between the second doped crystalline silicon conductive region 162 and the substrate 110, reduce a carrier recombination probability, and improve an efficiency of the solar cell. In an example, the second tunneling oxide layer 150 is made of silicon oxide.

In the second passivation layer 170, the second doped crystalline silicon conductive region 162 may be used as an emitter region to be in contact with the second electrode 180. In one or more embodiments, the second doped crystalline silicon conductive region 162 is made of doped polycrystalline silicon, doped nanocrystalline silicon, or silicon carbide. In the second passivation layer 170, the second wide bandgap conductive region 164 acts as a wide bandgap passivation layer that provides a better passivation effect and meanwhile reduces parasitic absorption. The second wide bandgap conductive region 164 may be arranged in exactly the same manner as the first doped crystalline silicon conductive region 134.

In one or more embodiments, the surface passivation structure 190 includes a passivation film 191 and an antireflection film 192. The passivation film 191 can ensure a good passivation effect on the second surface of the substrate 110. The antireflection film 192 can reduce an optical reflection loss of the second surface of the substrate 110, and improve a light absorption efficiency of the silicon-based bottom cell 10.

The passivation film 191 may be made of one of silicon oxide, aluminum oxide, silicon nitride, and silicon oxynitride. The passivation film 191 may have a single layer structure or a multilayer structure. For the multilayer structure, materials of different layers may be different from each other, and alternatively, the materials of some layers may be the same and different from the materials of other layers. For example, the passivation film 191 may have a multilayer structure of a silicon nitride layer and an aluminum oxide layer.

The antireflection film 192 may be made of one of silicon oxide, aluminum oxide, silicon nitride, and silicon oxynitride. The antireflection film 192 may have a single layer structure or a multilayer structure. For the multilayer structure, materials of different layers may be different from each other, and alternatively, the materials of some layers may be the same and different from the materials of other layers. For example, the antireflection film 192 may have a multilayer structure of a silicon nitride layer and an aluminum oxide layer.

In some embodiments, the second doped crystalline silicon conductive regions 162 and the second wide bandgap conductive regions 164 are alternately arranged along the X direction, thereby reducing a ratio of the second doped crystalline silicon conductive regions 162, reducing light parasitic absorption, and thus increasing the short-circuit current of the tandem cell. In addition, in some embodiments, the first surface 111 and the second surface 112 of the substrate 110 are both provided with composite passivation layers, so that the tandem cell has a higher performance.

In some embodiments, the substrate 110 is an N-type substrate, and the first doped crystalline silicon conductive region 132 and the first tunneling oxide layer 120 contain N-type doped elements; the second doped crystalline silicon conductive region 162 and the second tunneling oxide layer 150 contain P-type doped elements.

The substrate 110 has a doped element therein, and the doped element may be N-type or P-type. The N-type element may be group-V elements such as phosphorus (P), bismuth (Bi), antimony (Sb), or arsenic (As); the P-type element may be group-III elements such as boron (B), aluminum (Al), gallium (Ga), or indium (In). For example, when the substrate 110 is an N-type substrate, the internal doped element thereof is N-type.

In some embodiments, the substrate 110 may be an N-type substrate, and the substrate 110 may be doped with N-type doped ions, which may be, for example, any of phosphorous ions, bismuth ions, antimony ions, and arsenic ions.

Correspondingly, the first doped crystalline silicon conductive region 132 and the first tunneling oxide layer 120 contain the N-type doped elements. The first doped crystalline silicon conductive region 132 and the first tunneling oxide layer 120 may have doped elements with the same conductive type as the substrate 110. The doped element may be, for example, any of phosphorus ions, bismuth ions, antimony ions, and arsenic ions. The second doped crystalline silicon conductive region 162 and the second tunneling oxide layer 150 contain doped elements with the opposite conductive type to the substrate 110. The doped element may be, for example, boron ions, aluminum ions, or the like.

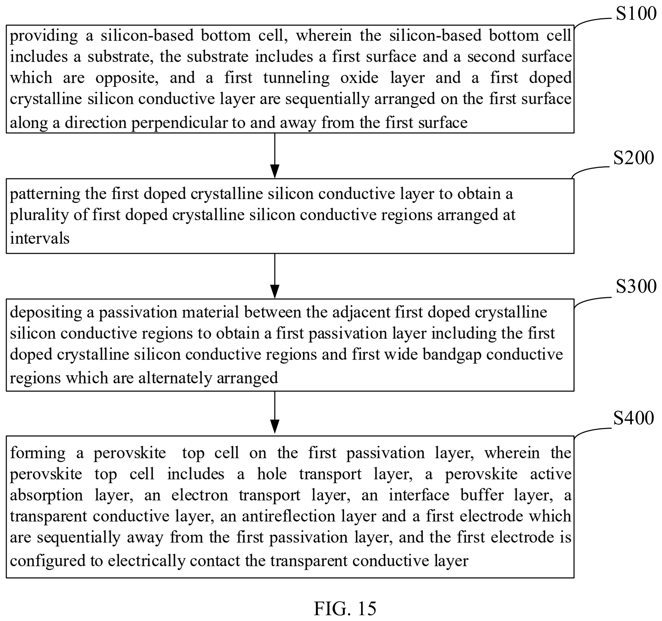

Referring to FIG. 15, a manufacturing method of the tandem cell 100 is provided. The manufacturing method of a tandem cell 100 includes the following steps.

S100: providing a silicon-based bottom cell 10, wherein the silicon-based bottom cell 10 includes a substrate 110, the substrate 110 includes a first surface 111 and a second surface 112 which are opposite, and a first tunneling oxide layer 120 and a first doped crystalline silicon conductive layer 130 are sequentially stacked on the first surface 111 along a direction perpendicular to and away from the first surface 111.

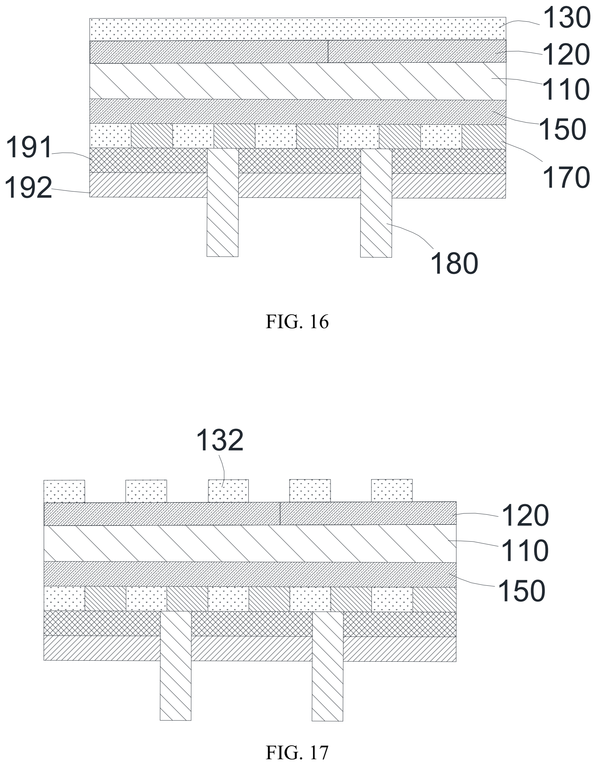

Referring to FIG. 16, in this step, the silicon-based bottom cell 10 is an N-type cell, and the substrate 110 is an N-type substrate 110. The first surface 111 of the substrate 110 is provided with the first tunneling oxide layer 120 and the first doped crystalline silicon conductive layer 130. In this step, the first doped crystalline silicon conductive layer 130 is an entire layer structure covering the first tunneling oxide layer 120.

S200: patterning the first doped crystalline silicon conductive layer 130 to obtain a plurality of first doped crystalline silicon conductive regions 132 arranged at intervals.

In some embodiments, referring to FIG. 16 and FIG. 17, the first doped crystalline silicon conductive layer 130 is patterned to form the plurality of first doped crystalline silicon conductive regions 132. Opening regions are formed between the adjacent first doped crystalline silicon conductive regions 132.

In an embodiment, the first doped crystalline silicon conductive layer 130 is patterned by using ultraviolet picosecond laser, excess parts of the first doped crystalline silicon conductive layer 130 are removed, and remaining parts of the first doped crystalline silicon conductive layer 130 form the plurality of first doped crystalline silicon conductive regions 132.

S300: depositing a passivation material between the adjacent first doped crystalline silicon conductive regions 132 to obtain a first passivation layer 140 including the first doped crystalline silicon conductive regions 132 and first doped crystalline silicon conductive regions 134 which are alternately arranged (refer to FIG. 14).

In some embodiments, nanocrystalline silicon oxide with the same thickness as the first doped crystalline silicon conductive region 132 is deposited between the adjacent first doped crystalline silicon conductive regions 132 by a masking method (or photolithography) to serve as a wide bandgap passivation layer, thereby providing a better passivation effect and meanwhile reducing parasitic absorption.

S400: forming a perovskite top cell 20 on the first passivation layer 140, wherein the perovskite top cell 20 includes a hole transport layer 210, a perovskite active absorption layer 220, an electron transport layer 230, an interface buffer layer 240, a transparent conductive layer 250, an antireflection layer 260 and a first electrode 270 which are sequentially away from the first passivation layer 140, and the first electrode 270 is configured to be in electrical contact with the transparent conductive layer 250.

In some embodiments, the hole transport layer 210, the perovskite active absorption layer 220, the electron transport layer 230, the interface buffer layer 240, the transparent conductive layer 250, the antireflection layer 260, and the first electrode 270 in electrical contact with the transparent conductive layer 250 are sequentially deposited on the first passivation layer 140, thereby forming the tandem cell.

In the manufacturing method of a tandem cell 100 according to the present invention, a passivation contact structure formed by the first tunneling oxide layer 120 and the first passivation layer 140 can be formed on the surface of the silicon-based bottom cell 10 facing the perovskite top cell 20, and the first passivation layer 140 includes the first doped crystalline silicon conductive regions 132 and the first doped crystalline silicon conductive regions 134 alternately arranged along the X direction, so that a ratio of the first doped crystalline silicon conductive regions 132 is reduced, and light parasitic absorption is reduced, thereby increasing a short-circuit current of the tandem cell.

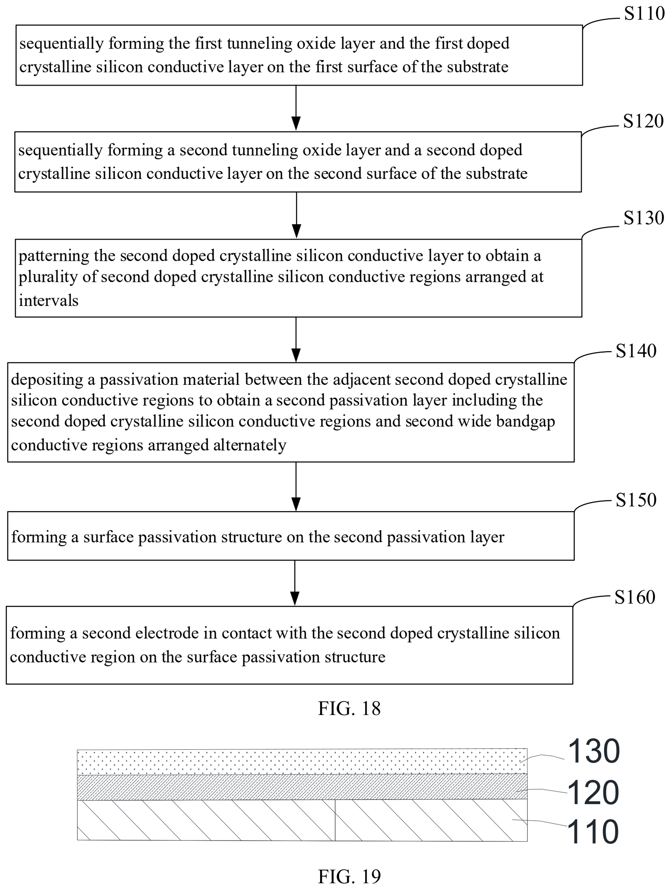

In some embodiments, referring to FIG. 18, S100 includes the following steps.

S110: sequentially forming the first tunneling oxide layer 120 and the first doped crystalline silicon conductive layer on the first surface 111 of the substrate 110, as shown in FIG. 19.

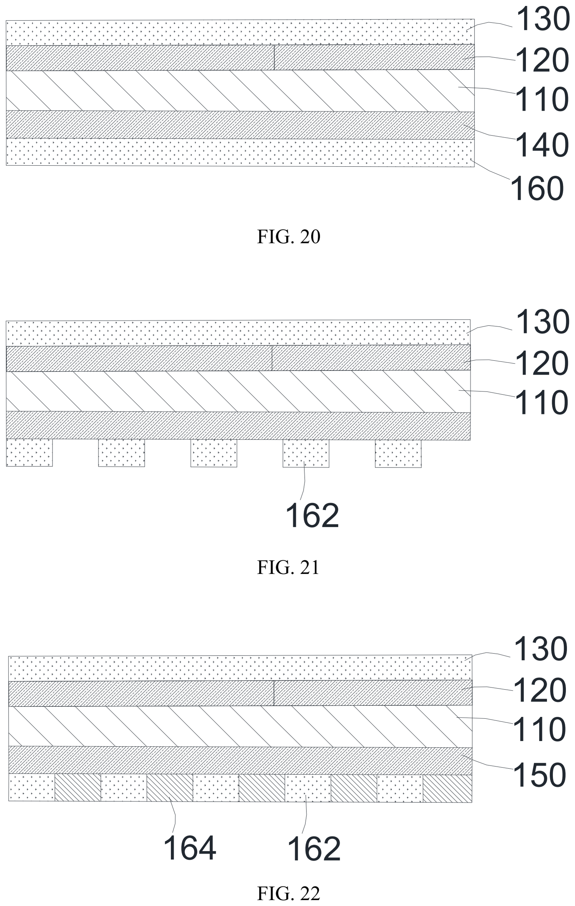

S120: sequentially forming a second tunneling oxide layer 150 and a second doped crystalline silicon conductive layer on the second surface 112 of the substrate 110, as shown in FIG. 20.

S130: patterning the second doped crystalline silicon conductive layer 160 to obtain a plurality of second doped crystalline silicon conductive regions 162 arranged at intervals, as shown in FIG. 21.

S140: depositing a passivation material between the adjacent second doped crystalline silicon conductive regions 162 to obtain a second passivation layer 170 including the second doped crystalline silicon conductive regions 162 and second wide bandgap conductive regions 164 arranged alternately, as shown in FIG. 22.

S150: forming a surface passivation structure 190 on the second passivation layer 170, as shown in FIG. 14.

S160: forming a second electrode 180 in contact with the second doped crystalline silicon conductive region 162 on the surface passivation structure 190, as shown in FIG. 14.

In some embodiments, the first surface 111 and the second surface 112 of the substrate 110 may be textured with an alkali solution and a texturing additive respectively to form micro-scale pyramid structures. Then, silicon oxide and polycrystalline silicon are deposited on the first surface 111 by LPCVD, and then, phosphorus diffusion is performed to obtain the first tunneling oxide layer 120 and the first doped crystalline silicon conductive layer 130. Silicon oxide and polycrystalline silicon are deposited on the second surface by LPCVD, and then, boron diffusion is performed to obtain the second tunneling oxide layer 150 and the second doped crystalline silicon conductive layer 160. In some embodiments, nanocrystalline silicon oxide with the same thickness as the second doped crystalline silicon conductive region 162 is deposited between the adjacent second doped crystalline silicon conductive regions 162 by a masking method (or photolithography) to serve as a wide bandgap passivation layer, thereby providing a better passivation effect and meanwhile reducing parasitic absorption. Aluminum oxide is deposited by ALD, and silicon nitride is deposited by PECVD, thus realizing further passivation and reducing an optical loss. Finally, the electrode is deposited by adopting screen printing to form the complete crystalline silicon cell.

In some embodiments, the passivation contact structure formed by the second tunneling oxide layer 150 and the second passivation layer 170 is formed on the second surface of the silicon-based bottom cell 10, and the second passivation layer 170 includes the second doped crystalline silicon conductive regions 162 and the second wide bandgap conductive regions 164 alternately arranged in the direction parallel to the second surface 112, so that a ratio of the second doped crystalline silicon conductive regions 162 is reduced, and light parasitic absorption is reduced, thereby increasing a short-circuit current of the tandem cell. In addition, in the present invention, the first surface 111 and the second surface 112 of the substrate 110 are both provided with composite passivation structures, so that the tandem cell has a higher performance.

In the present invention, the passivation material is an insulating dielectric material with a large energy bandgap (much larger than that of silicon) such as tungsten disulfide, molybdenum disulfide, titanium oxide, molybdenum oxide, tungsten oxide, hydrogenated amorphous silicon carbide, amorphous silicon oxide, or metal oxide. The passivation material can form the wide bandgap passivation layer that provides a better passivation effect and meanwhile reduces parasitic absorption.

In some embodiments, before S200, the manufacturing method further includes: washing the first surface 111 with hydrofluoric acid to expose the first doped crystalline silicon conductive layer 130.

In this step, the hydrofluoric acid (HF) is adopted for washing to remove surface metallization, silicon nitride and oxide layers, and the first doped crystalline silicon conductive layer 130 is exposed, so that the first doped crystalline silicon conductive layer 130 can be conveniently patterned.

In some embodiments, S200 includes: removing 20% to 80% of the first doped crystalline silicon conductive layer 130. In one or more embodiments, 70% of the first doped crystalline silicon conductive layer 130 is removed.

In some embodiments, before S400, the manufacturing method further includes: forming a second conductive film layer 30 on the first passivation layer 140.

The tandem cell 100 according to the embodiment of the present invention will be illustrated below in conjunction with some examples and related comparative examples.

### Fifth example

A silicon wafer was provided, and a surface of the silicon wafer was textured by adopting an alkali solution and a texturing additive to form a micro-scale pyramid structure; silicon oxide and polycrystalline silicon were deposited by LPCVD, and then, boron diffusion was performed to obtain a second tunneling oxide layer 150 and a second doped crystalline silicon conductive layer 160.

Silicon oxide and polycrystalline silicon were deposited by LPCVD, and then, phosphorus diffusion was performed to obtain a first tunneling oxide layer 120 and a first doped crystalline silicon conductive layer 130.

The second doped crystalline silicon conductive layer 160 was patterned by using ultraviolet picosecond laser, so as to remove 70% of the second doped crystalline silicon conductive layer 160, that is, reserve 30% of the second doped crystalline silicon conductive region 162, and a second doped crystalline silicon conductive region 162 is in a strip shape and has a width of 50um.

An alkali polishing process was adopted to reduce damage of the laser to the silicon wafer.

Nanocrystalline silicon oxide with the same thickness as the second doped crystalline silicon conductive layer 160 was deposited by a masking method (or photolithography) to serve as a wide bandgap passivation layer, thereby providing a better passivation effect and meanwhile reducing parasitic absorption.

On the second doped crystalline silicon conductive layer 160, aluminum oxide was deposited by ALD, and silicon nitride was deposited by PECVD, thus realizing further passivation and reducing an optical loss.

A second electrode 180 was deposited by using screen printing to form a complete silicon-based bottom cell 10.

Surface metallization, silicon nitride and oxide layers were removed by HF washing, so as to expose the first doped crystalline silicon conductive layer 130.

Nanocrystalline silicon oxide with the same thickness as the first doped crystalline silicon conductive layer 130 was deposited by a masking method (or photolithography) to serve as a wide bandgap passivation layer, thereby providing a better passivation effect and meanwhile reducing parasitic absorption.

50nm ITO (indium zinc oxide) was deposited by magnetron sputtering as a second conductive film layer 30 as an intermediate composite layer of a tandem cell.

A hole transport layer 210, a perovskite active absorption layer 220, an electron transport layer 230, an interface buffer layer 240, a transparent conductive layer 250, an antireflection layer 260 and a first electrode 270 were sequentially deposited to form the complete tandem cell.

Sixth example: the sixth example is different from the fifth example in that an area of a first doped crystalline silicon conductive region 132 accounts for 70%, and an area of the second doped crystalline silicon conductive region 162 accounts for 70%.

Seventh example: the seventh example is different from the fifth example in that the first doped crystalline silicon conductive region 132 has a width of 200um and the second doped crystalline silicon conductive region 162 has a width of 200um.

Eighth example: the eighth example is different from the fifth example in that a material of the wide bandgap passivation layer is titanium oxide. A bandgap of the titanium oxide is wider than that of the nanocrystalline silicon oxide of the fifth example, the short-circuit current is higher than that of the fifth example, and meanwhile, the titanium oxide can provide better passivation and thus realizes a higher open-circuit voltage.

Second comparative example: the second comparative example is different from the fifth example in that the steps of patterning the first doped crystalline silicon conductive layer 130 and the second doped crystalline silicon conductive layer 160 and the steps of depositing passivation materials to form the first doped crystalline silicon conductive region 134 and the second wide bandgap conductive region 164 were omitted.

IV volt-ampere characteristic curves of the above tandem cells were tested, and the test was performed with reference to GBT6495.1 (name: IEC60904-2008). Testing conditions: spectrum: AM1.5G, light intensity: 1,000W/m2, and temperature: 25°C. Test results are given in the table below.

**Table 2**

| | Voc(V) Open-circuit voltage | Jsc(mA/cm2) Short-circuit current density | FF(%) Filling factor | PCE(%) |
|---|---|---|---|---|
| Second comparative example | 1.884 | 18.92 | 80.32 | 28.63 |
| Fifth example | 1.916 | 19.35 | 81.25 | 30.12 |
| Sixth example | 1.91 | 19.11 | 81.05 | 29.58 |
| Seventh example | 1.905 | 19.29 | 80.95 | 29.75 |
| Eighth example | 1.921 | 19.44 | 81.19 | 30.32 |

As can be seen from table 2, compared with the comparative example, the tandem cell 100 according to the embodiment of the present invention has a better filling factor, a higher open-circuit voltage, and a larger short-circuit current density as a whole.

## Claims

1. A tandem solar cell, comprising:
a silicon-based bottom cell including:
a substrate having a first surface and a second surface that are opposite;
a first tunneling oxide layer arranged on the first surface; and
a first passivation layer arranged on the first tunneling oxide layer; and
a perovskite top cell arranged on the first passivation layer and electrically connected to the silicon-based bottom cell, the perovskite top cell including:
a hole transport layer, a perovskite active absorption layer, an electron transport layer, an interface buffer layer, a transparent conductive layer, an antireflection layer, and a first electrode that are sequentially stacked on the first passivation layer, wherein the first electrode is configured to electrically contact the transparent conductive layer.

2. The tandem cell according to claim 1, wherein the silicon-based bottom cell further comprises a first doped crystalline silicon conductive layer arranged on the first tunneling oxide layer, the first doped crystalline silicon conductive layer has a plurality of first opening regions exposing the first tunneling oxide layer or the substrate, and the first passivation layer covers a surface of the first doped crystalline silicon conductive layer and surfaces of the plurality of first opening regions.

3. The tandem cell according to claim 2, wherein the first doped crystalline silicon conductive layer comprises a plurality of first doped crystalline silicon conductive regions arranged at intervals, and the plurality of first opening regions are formed between adjacent first doped crystalline silicon conductive regions;
or, wherein the first doped crystalline silicon conductive layer is a first grid lay-out structure.
or, wherein a first conductive film layer is further arranged between the hole transport layer and the first passivation layer.

4. The tandem cell according to claim 2, wherein the silicon-based bottom cell further comprises a second tunneling oxide layer arranged on the second surface, a second passivation layer arranged on the second tunneling oxide layer, and a second electrode arranged on the second passivation layer.

5. The tandem cell according to claim 2, wherein the silicon-based bottom cell further comprises a second tunneling oxide layer arranged on the second surface, a second doped crystalline silicon conductive layer and a second passivation layer arranged on the second tunneling oxide layer, and a second electrode arranged on the second passivation layer, the second doped crystalline silicon conductive layer has a plurality of second opening regions exposing the second tunneling oxide layer or the substrate, and the second passivation layer covers a surface of the second doped crystalline silicon conductive layer and a surface of the second tunneling oxide layer, and the second electrode is configured to electrically contact the second doped crystalline silicon conductive layer.

6. The tandem cell according to claim 5, wherein the second doped crystalline silicon conductive layer comprises a plurality of second doped crystalline silicon conductive regions arranged at intervals, and the second opening regions are formed between adjacent second doped crystalline silicon conductive regions.

7. The tandem cell according to claim 5, wherein the second doped crystalline silicon conductive layer is a second grid lay-out structure, and meshes of the second grid lay-out structure form the second opening regions.

8. The tandem cell according to claim 5, wherein the substrate is an N-type substrate, the first doped crystalline silicon conductive layer and the first tunneling oxide layer each comprises N-type doped elements, and the second doped crystalline silicon conductive layer and the second tunneling oxide layer each comprises P-type doped elements.

9. The tandem cell according to claim 1, wherein along a direction parallel to the first surface, the first passivation layer comprises a plurality of first doped crystalline silicon conductive regions and a plurality of first wide bandgap conductive regions that are alternately arranged.

10. The tandem cell according to claim 9, wherein along the direction perpendicular to and away from the first surface, the first doped crystalline silicon conductive region and the first wide bandgap conductive region have equal thicknesses.

11. The tandem cell according to claim 9, wherein an area of all the first doped crystalline silicon conductive regions accounts for 20% to 80% of an area of the first passivation layer;
or, along the direction parallel to the first surface, each of the first doped crystalline silicon conductive regions has a width of 50 to 250µm;
or, a second conductive film layer is further arranged between the perovskite top cell and the first passivation layer.

12. The tandem cell according to claim 9, wherein the silicon-based bottom cell further comprises a second tunneling oxide layer, a second passivation layer, a surface passivation structure, and a second electrode that are sequentially stacked on the second surface, along a direction parallel to the second surface, the second passivation layer comprises second doped crystalline silicon conductive regions and second wide bandgap conductive regions that are alternately arranged, and the second electrode is in contact with the second doped crystalline silicon conductive regions.

13. The tandem cell according to claim 12, wherein the substrate is an N-type substrate, the first doped crystalline silicon conductive region and the first tunneling oxide layer comprise N-type doped elements, and the second doped crystalline silicon conductive region and the second tunneling oxide layer comprise P-type doped elements.

14. The tandem cell according to claim 12, wherein at least one of the first wide bandgap conductive region and the second wide bandgap conductive region are made of a material selected from the group consisting of tungsten disulfide, molybdenum disulfide, titanium oxide, molybdenum oxide, tungsten oxide, hydrogenated amorphous silicon carbide, amorphous silicon oxide, and metal oxide.

15. The tandem cell according to claim 12, wherein at least one of the first doped crystalline silicon conductive region and the second doped crystalline silicon conductive region are made of a material selected from the group consisting of doped polycrystalline silicon, doped nanocrystalline silicon, and silicon carbide;
or, wherein the surface passivation structure comprises a passivation film and an antireflection film.
